# EUROPEAN PATENT APPLICATION

(11) **EP 4 653 902 A1**
(43) Date of publication of application: **26.11.2025**
(21) Application number: 24177925.5
(22) Date of filing: 24.05.2024
(51) Int. Cl.: G01R 33/28, G01R 33/54, G01R 33/3815

(54) **SAFETY METHODS AND SYSTEMS FOR QUICKLY RAMPABLE MAGNETIC RESONANCE IMAGING SYSTEMS**

(71) Applicant: Koninklijke Philips N.V., 5656 AG Eindhoven (NL)
(72) Inventor: AMTHOR, Thomas Erik, Eindhoven (NL); FORTHMANN, Peter, Eindhoven (NL)
(74) Representative: Philips Intellectual Property & Standards

(57) **Abstract**

Methods and systems for safety of magnetic resonance imaging are disclosed, in particular for improving safety of quickly rampable magnetic resonance imaging systems. The invention proposes to use a magnet based on high-temperature superconductor technology in combination with an automated ramp-down system that safely turns off the magnetic field whenever the MRI is not actively being used. In this way it can be ensured that a system which is not in use without a human operator nearby is always in a safe state.

## Description

### TECHNICAL FIELD

The subject-matter described herein relates to safety methods and systems for magnetic resonance imaging.

### BACKGROUND

Image-forming magnetic resonance (MR) methods that utilize the interaction between magnetic fields and nuclear spins in order to form two-dimensional or three-dimensional images are widely used nowadays, notably in the field of medical diagnostics, due to their superiority for imaging soft tissue to other imaging methods, mainly because of not requiring ionizing radiation and being usually not invasive.

Standard MR magnets based on low-temperature superconductors cannot be turned off easily, therefore, the dangerous high magnetic field is always present, even while the magnetic resonance imaging (MRI) is not in use.

Novel high-temperature superconductor (HTS) materials, such as MgB₂, allow construction of quickly rampable MR magnets. Such magnets tolerate change of the magnetic field strength for different applications or to be turned on and off completely on demand.

The information included in this Background section of the specification, including any references cited herein and any description or discussion thereof, is included for technical reference purposes only and is not to be regarded as subject-matter by which the scope of the disclosure is to be bound.

### SUMMARY

The objective of the invention is to provide systems and methods for improving safety of quickly rampable MRI system. The invention proposes to use a magnet based on high-temperature superconductor technology in combination with an automated ramp-down system that safely turns off the magnetic field whenever the MRI is not actively being used. In this way it can be ensured that a system which is not in use without a human operator nearby is always in a safe state.

In one aspect, the invention provides a method of operating a rampable MRI system, comprising: presenting a resettable count-down timer to a user, wherein the count-down starts from a predefined value; resetting the count-down timer to the predetermined value upon interaction of a user; assessing current use of the MRI system based on whether an examination is ongoing or whether an examination is scheduled within a predetermined time interval; ramping down the magnetic field strength of the MRI system when the duration of period associated to the predefined value elapses and when current use of the MRI system is not established.

In an embodiment the method further comprises presenting the user a warning signal when the duration of period associated to the predefined value is about to elapse. The warning signal may be a visual and/or an audible signal. Any notification and/or warning may be carried out by a mobile device, such as for example a smartphone, and/or a fixed device such as for example a display screen of a console or connected to the console and/or a projecting device.

In some of the embodiments the predetermined value may be set by an operator of the MRI system and/or it may be selected from a list of predetermined values through a user interface.

In some embodiments the method may further comprise: receiving information about an actual active magnetic field strength associated to the MRI system; receiving a request from a user willing to access a location wherein the MRI system is sited; receiving a user access profile associated to the user requesting access to the location; granting user access to the location when the actual active magnetic field strength is in conformity with the user access profile.

In some embodiments ramping down the magnetic field strength of the MRI system to a first predetermined field strength value is performed when the duration of period associated to the predefined time interval value elapses and when current use of the MRI system for high-resolution imaging is not established; and the method further comprises: scanning at least one portion of a subject at magnetic field strength according to the first predetermined value; detecting from the scanning whether the at least one portion of the subject comprises metal; ramping up the magnetic field strength of the MRI system to a second predetermined field strength value based on detecting no metal being comprised by the at least one portion of the subject, wherein the second predetermined field strength value is larger than the first predetermined field strength value; imaging the at least one portion of the subject at magnetic field strength according to the second predetermined field strength value.

In a further aspect, the invention provides a method of controlling access to a location wherein a rampable MRI system is situated, comprising: receiving information about an actual active magnetic field strength associated to the MRI system; receiving a request from a user willing to access the location wherein the MRI system is situated; receiving a user access profile associated to the user requesting access to the location; granting user access to the location when the actual active magnetic field strength is in conformity with the user access profile.

For a quickly rampable magnet with changing operating conditions and changing magnetic field strengths the risk level when entering the room may not always be obvious or clear. Even with a field strength indicator in place, the risk of a person entering the room with a wrong assumption or expectation of the system state is much higher than in the case of a conventional superconducting MR magnet that is simply always on.

The method may further comprise notifying the user when the time interval permitted to be spent in the location is about to elapse. In an embodiment the time interval permitted to be spent in the location by the user is associated to the user access profile.

In some embodiments the method may comprise notifying a supervisor of the location that the user has gained access to the location and/or that the time interval the respective user is allowed to spend within the location is about to elapse. In some embodiments notifying may be performed by a visual signal and/or an audible signal.

In a yet further aspect, the invention provides a method of operating a rampable magnetic resonance imaging system, comprising: ramping down the magnetic field strength of the MRI system to a first predetermined value; scanning at least one portion of a subject at magnetic field strength according to the first predetermined value; detecting from the scanning whether the at least one portion of the subject comprises metal; ramping up the magnetic field strength of the MRI system to a second predetermined value based on detecting no metal being comprised by the at least one portion of the subject, wherein the second predetermined value is larger than the first predetermined value; imaging the at least one portion of the subject at magnetic field strength according to the second predetermined value.

In case that it is unknown whether patients have metallic objects in their body, magnetic resonance imaging is contraindicated. This may deprive a significant patient population of the advantages of this diagnostic modality.

Further method embodiments are disclosed and discussed in the detailed description of the invention.

In a further aspect, the invention provides a system for safe operation of a magnetic resonance imaging system, wherein the system comprises a computational system configured to perform a method according to any of the hereinbefore presented method embodiments.

In an embodiment the system further comprises a magnetic resonance imaging system for providing magnetic resonance imaging data; and a device configured to present information output by the computational system. The output device may be a mobile device, such as for example a smartphone, and/or a fixed device, such as for example a display screen of a console or connected to the console and/or a projecting device.

In yet a further aspect of the invention a computer program is presented, comprising machine executable instructions, wherein execution of the machine executable instructions causes a computational system to perform any of the method embodiments.

Features described above with respect to method embodiments are applicable and are contemplated also for corresponding system embodiments, with similar benefits.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the system embodiment and method embodiments, as defined in the claims, is provided in the following written description of various embodiments of the disclosure and illustrated in the accompanying drawings.

### BRIEF DESCRIPTION OF THE DRAWINGS

Illustrative embodiments of the present disclosure will be described with reference to the accompanying drawings, of which:
Figure 1 illustrates an example of a system according to the invention;
Figure 2 schematically illustrates a flowchart according to an embodiment of the invention;
Figure 3 schematically illustrates a flowchart according to a further embodiment of the invention.

### DETAILED DESCRIPTION

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

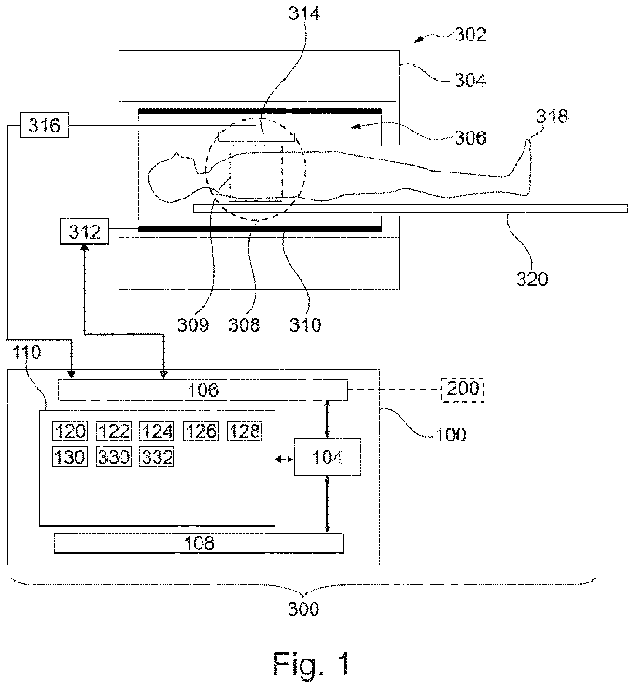

Fig. 1 illustrates an example of a system 300, which may be a medical system. The medical system 300 comprises the computer system 100 and a magnetic resonance imaging system 302, or with other words a magnetic resonance imaging scanner. The computer system 100 may be termed control and/or processing system 100, whereas both the computer system and the MRI system may also be termed sub-systems.

The magnetic resonance imaging system 302 comprises a magnet 304. The magnet 304 is a superconducting cylindrical-type magnet with a bore 306 through it. The use of different types of magnets is also possible; for instance, it is also possible to use both a split cylindrical magnet and a so-called open magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject: the arrangement of the two sections is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A region of interest 309 is shown within the imaging zone 308. Magnetic resonance data is typically acquired for the region of interest. A subject 318 is shown as being supported by a subject support 320 such that at least a portion of the subject 318 is within the imaging zone 308 and the region of interest 309.

Within the bore 306 of the magnet there is also a set of magnetic field gradient coils 310, which is used for acquisition of (preliminary) magnetic resonance data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308, there is a radiofrequency coil 314 for manipulating the orientations of magnetic spins within the imaging zone 308 and also for receiving radio transmissions from spins within the imaging zone 308. The radiofrequency coil may also be referred to as a channel or antenna. The radiofrequency antenna may contain multiple coil elements. The coil elements may be integrated in a flexible mat, in a rigid structure or their hybrid combination. The radiofrequency coil 314 is connected to a radiofrequency transceiver 316. The radiofrequency coil 314 and radio frequency transceiver 316 may be replaced by separate transmit and receive coils and a separate transmitter and receiver. It is understood that the radiofrequency coil 314 and the radiofrequency transceiver 316 are representative. The radiofrequency coil 314 is intended to also represent a dedicated transmit antenna and a dedicated receive antenna. Likewise, the transceiver 316 may also represent a separate transmitter and receivers. The radiofrequency coil 314 may also have multiple receive/transmit elements and the radiofrequency transceiver 316 may have multiple receive/transmit channels.

The transceiver 316 and the gradient controller 312 are shown as being connected to the hardware interface 106 of the computer system 100.

In this example, the computer system 100, which can further be implemented as a control and processing console of the MRI system, may represent one or more computer systems that are in one location or are distributed. The computer system 100 is shown as including a computational system 104. The computational system 104 may for example be one or more processing cores that are located at one or more locations. The computational system 104 is shown as being connected to an optional hardware interface 106. The hardware interface 106 may for example be used to connect the computational system 104 with other components of the computer system 100 if they are present. The hardware interface 106 may enable the computational system 104 to control such components.

The computer system is further shown as comprising an optional user interface 108. The user interface 108 may for example be used by an operator to control the operation and functioning of the computer system 100. The computer system 100 could be a standalone computer system but it could also be integrated into a magnetic resonance imaging system.

The computer system is further shown as comprising a memory 110. The memory 110 is intended to represent any combination of memory or storage device which is accessible to the computational system 104. The memory 110 may include volatile and non-volatile memory storage means and components. The memory 110 in some embodiments may be based on or may rely on cloud-based data stored in logical pools across disparate, commodity storage servers located on premises or in a data center managed by a third-party cloud provider. Accordingly, the memory as schematically depicted in Fig. 1 is just for illustration purposes. Therefore, any or all components comprised in memory 110 may be cloud-based.

The memory 110 is shown as containing machine-executable instructions 120. The machine-executable instructions 120 may be configured to enable the computational system 104 to perform basic data processing and image processing tasks, such as reconstructing magnetic resonance images. The machine-executable instructions 120 may also in some examples contain code, which enables the computational system to control other components via the optional hardware interface 106.

The memory 110 may comprise image segmentation algorithm 122. The image segmentation algorithm 122 may be a standard magnetic resonance imaging image segmentation algorithm that is configured for outputting one or more predetermined anatomical regions for magnetic resonance imaging data. This may be for a particular field of view or anatomical region of the subject, e.g., one or multiple anatomical structures or organs of a patient.

The memory 110 may comprise or store the measured magnetic resonance imaging data 124. The memory 110 may further comprise an image segmentation 126 that has been received from the image segmentation algorithm 122 by inputting the measured magnetic resonance imaging data 124. The memory 110 may comprise a selected image portion 128. This is one or more regions or anatomical regions that have been identified in the image segmentation 126. The selected image portion 128 may for example be selected using a predetermined criterion that is applied to the image segmentation 126. The memory may comprise one or a plurality of several algorithms 130 for deriving several contrasts within the region of interest 309 of an imaging zone 308 based on magnetic resonance imaging data 124 and by optionally using any information present in the memory 110 and/or information that may be input by a user through the user interface 108.

The memory 110 is shown as containing pulse sequence commands 330. The pulse sequence commands are commands or data, which can be converted into commands that can be used to control the magnetic resonance imaging system 302 to acquire k-space data 332. Examples of pulse sequence comprised by the pulse sequence commands 330 may be any of a spin-echo imaging sequence, a gradient-echo imaging sequence and one of their hybrid combination.

The memory 110 is further shown as comprising k-space data 332 that has been acquired by controlling the magnetic resonance imaging system 302 with the pulse sequence commands 330. The computational system 104 may also reconstruct the measured magnetic resonance imaging data 124 from the k-space data 332.

According to the invention, the superconducting magnet 304 is formed with coils comprising high-temperature superconductor (HTS) material, such as any of MgB₂, rare-earth barium copper oxide (ReBCO), bismuth strontium calcium copper oxide (BSCCO), which allows for the construction of quickly rampable MR magnets. Such magnets can in principle be easily switched off when not in use, in order to minimize risks associated with the strong magnetic field.

Examples of magnetic resonance imaging systems with superconducting magnet comprising HTS material are for instance presented in the European patent application 23197904 filed on September 18, 2023, and European patent application 24159684 filed on February 26, 2024, which are incorporated by reference herein in their entirety.

For reasons of simplicity, it is referred to the safe state as 'turned off. This does not necessarily mean zero magnetic field. In order to accelerate a later ramp-up, it is possible to ramp-down the magnet to a much lower field strength, though not to ramp-down the magnet completely, e.g., leave the magnetic field at some low magnetic field strength in the order of 0.1T.

Due to the high main magnetic field strengths of MR magnets, entering the MR examination room always requires safety precautions. For example, magnetic objects may not be brought into the room, because the risk for injuries or device damage is high. Personnel entering the MR examination room need special training and must be very aware of any potential hazards. For safety reasons, it is also not advisable to enter the MR examination room when there is no other person nearby to help in case of an emergency. Untrained clinical staff, cleaning staff, or temporary workers are always at risk when working near the MR magnet.

According to an embodiment, the system 300 comprises a system to ramp-down the magnetic field on reception of a trigger signal. This may be implemented in the computer system 100 or as a separate system such as a console 200 connected to the computer system and the MRI system 302 through the hardware interface 106.

Additionally, the ramp-down system comprises a ramp-down timer indicator, a visual or audible ramp-down warning device, a device to inquire regular user interaction or feedback, such as for example an input from the user by pushing a button, when the regular magnetic field strength is still needed, and a device to infer status of the magnet from the MR system or from user interface interactions, e.g., examination state, current use, etc. Any or all of the following devices: timer, warning device, interaction device, device to infer status of the magnet, may be peripheral devices coupled to the user interface 108 through wired or wireless connection and/or being associated to the separate console 200 coupled to the hardware interface 106.

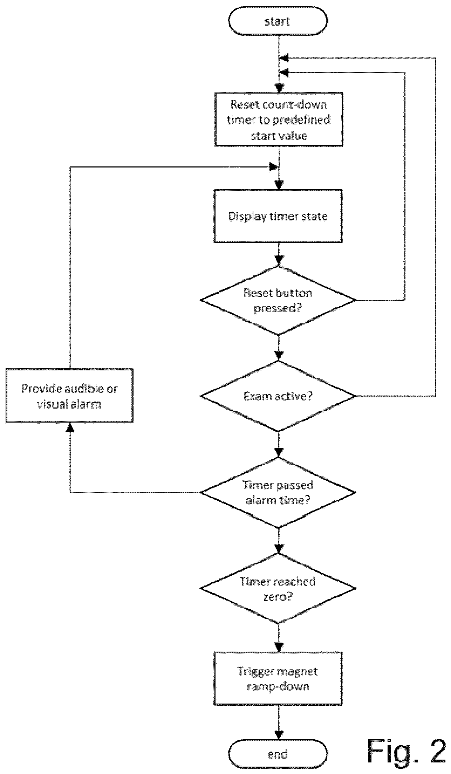

With reference to Fig. 2 a method of operation of an MRI system is illustrated, comprising a decision tree for determining whether a magnet can or cannot be ramped down. A resettable count-down timer is presented to the user, wherein the value may be predefined, e.g., from a selection of predefined values and/or a value input by the user into the system. The timer is displayed on a display screen as counting down from the predetermined value and a user interaction is required at least at intervals being at most the predetermined value, to reset the count-down timer, such that the timer starts counting down again from the predetermined value. The timer may be shown on a display (projected) on the wall and/or through a computer screen and/or on a mobile device, and it may be for example in the form of minutes and seconds and/or a progress bar. The user interaction may occur through pressing or clicking a button or a keyboard on the user interaction device, e.g., mouse, keyboard, joystick, or by touching an icon or a tab on a display screen.

In the event that the user does not interact with the feedback device, the system identifies automatically whether an examination is actively being pursued or not. The user may be distracted from interacting regularly with the interaction device to reset the count-down timer due to tasks during ongoing examination, and it has to be prevented an examination being affected by an inopportune ramp-down. In case that an examination is ongoing or active, the count-down timer is automatically reset to the predefined value and/or kept at the predefined value. Automatic identification of an ongoing examination can be realized by an adapted MRI host software, providing an interface to the ramp-down system, for example in the form of an Application Programming Interface (API) or a data streaming interface. The MRI host software will then provide information about the status of the examination, e.g., if the exam is still ongoing or it has been finished. Additionally or alternatively, the system may automatically identify whether an examination is scheduled within a time-interval that would not allow a cost-efficient ramp-down of the magnet, for example when two consecutive examinations are separated by a time interval that is longer than the predefined value, but it is shorter than what an energy cost efficient ramp-up would allow. In case that the ramp-down system is offered as a retrofit solution for an MRI system and console software changes are impossible, the active system usage can be inferred by analyzing the console screen via screen capture, or by monitoring the mouse and keyboard actions by tapping into the respective USB connections.

When there is no active examination and an interaction from the user through the user interaction device is not received, then a warning signal is output to the warning device, which may be a visual and/or audible signal, through which the attention of the user can be attracted to interact with the interaction device to actively reset the count-down timer. The warning device may be a mobile device, such as for example a smartphone, and/or a fixed device such as for example a display screen of the console or connected to the console and/or a projecting device.

In case that such user interaction is not received by the system in a limited time interval, it is automatically triggered the magnet ramp-down to a safe state, to a lower magnetic field strength. Optionally, at the inception of the ramp-down procedure a corresponding second audible or visual notification may be provided.

In various embodiments the predetermined value of the time interval may be several minutes, half an hour, an hour or several hours.

In some embodiments the predetermined value may be a first predetermined value, and the warning signal may be output at a second predetermined time value prior to expiration of the time interval defined by the first predetermined value. The second predetermined value is smaller than the first predetermined value, with other words the time interval defined by the first predetermined value is longer or much longer than the time interval defined by the second predetermined value. In some nonlimiting examples the second predetermined value may be one minute, two minutes, five minutes or ten minutes.

In alternative embodiments the first predetermined value defines the time interval that needs to elapse until a warning signal is output. The second predetermined value defines a time interval that starts after the warning signal has been output, and expresses the time interval that needs to elapse between outputting the warning signal and the moment when the magnet ramp-down is initiated.

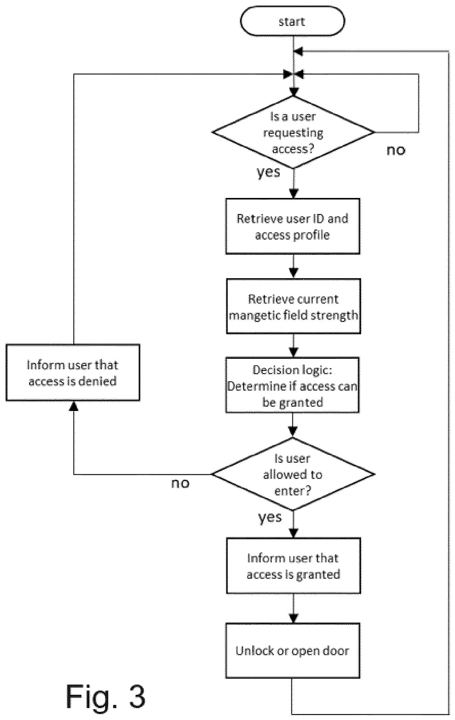

Fig. 3 schematically illustrates a method of permitting access to a location wherein a rampable magnetic resonance imaging system is present, comprising a decision tree for a field-dependent MR access control.

For a quickly rampable magnet with changing operating conditions and changing magnetic field strengths the risk level when entering the room may not always be obvious or clear. The magnetic field strength may have been changed in-between two visits to the room of one and the same person. Even with a field strength indicator in place, the risk of a person entering the room with a wrong assumption or expectation of the system state is much higher than in the case of a conventional superconducting MR magnet that is simply always on.

According to an embodiment, the system 300 comprises an access control system for the MR room that is taking into account the currently active magnetic field strength. This may be implemented in the computer system 100 or as a separate system such as a console 200 connected to the computer system and the MRI system 302 through the hardware interface 106. The system or the console may comprise also the automatic ramp-down system of the magnet, as discussed hereinbefore.

Accordingly, access to the room can be denied for untrained clinical staff while the field strength is too high. Cleaning staff may only be granted access when the magnet is turned off completely. Access rights may be granted selectively depending on the role and training status of the person requesting access and the currently active magnetic field strength.

In an embodiment the system comprises a field sensor configured to measure the currently active magnetic field strength.

An access control system is configured for checking user identity, receiving information about the currently active magnetic field from the field sensor, using a decision logic to determine access rights for the user under the given field conditions and operating a physical door lock and/or door opener depending on the determined access rights.

Returning to Fig. 3, the access control system is in standby, waiting for a user to request access. Requesting access can be realized in different ways, though the system must incorporate means for unique identification of each user that has associated access profile, for example by at least one of presenting an RFID tag at an RFID reader device next to the door, using a fingerprint reader next to the door, using a camera-based face or iris scanner next to the door.

Once a user has requested access to an MR examination room, the system retrieves the user identifier and, based on the user identifier, it retrieves the user access profile from a database.

The user access profile may include at least one of the following information: the maximum field strength the respective user is allowed to operate in, the maximum time interval the user is allowed to spend in the room, which may be dependent on the field strength, time intervals during a regular period such as for example a day or a week in which the user is allowed to enter the MR examination room.

Examples of user access profiles may include at least one of the following: cleaning staff with access only possible when the magnetic field is completely turned off, clinical staff with a pacemaker with access only possible when magnetic field is below the value certified as safe by the pacemaker manufacturer, clinical staff with safety training for magnetic field strengths up to predetermined level, clinical staff with access only possible when magnetic field is below a further predetermined level. Additionally or alternatively, time constraints for the maximum time interval to spend inside the room may apply for each user access profile.

The user access profile may also be role-based. In this case, in a first step, the user's role can be identified from a first database table, mapping the user identifier to the user's role. In a second step, using a second database table, the user role can be mapped to a role-based access profile.

The decision logic retrieves information about the currently active magnetic field strength from the field sensor and matches it to the user access profile. Alternatively, instead of retrieving the currently active magnetic field strength from the field sensor, the field strength information can be retrieved from a database of predetermined field strength values matched to the time interval elapsed from the inception of the magnet ramp-down as discussed hereinbefore, which could have been validated with historical field strength measurements. In the event that the conditions of the user access profile are met given the current magnetic field strength, the user will be granted access and optionally, will be notified about the access being granted. When the conditions of the access profile are not met given the current magnetic field strength, the user will be denied access and optionally, will be notified about the access being denied.

When the decision logic determines that the user may be granted access to the MR examination room the admission system is triggered, which may be a physical door lock and/or door opener such as a mechanism and/or an electromechanical system for opening and closing the door. Subsequently, the system then returns to its initial state to wait for the next user to request access.

In one embodiment of the invention, the maximum time interval that the user is allowed to spend in the MR examination room is limited to predetermined duration. The system is therefore configured to notify the user when the time interval is about to elapse so that the user can leave the room again. The notification can be realized by audible and/or visible prominent signal, such as intermittent intensity variation of a sound signal in the room and/or (intensity variation of) illumination of the room. Additionally or alternatively the notification can be realized acoustically for example by speech synthesis or visually for example by displaying information on a screen or projecting information on a wall. In an embodiment, the count-down of the maximum time allowed to be spent in the room by the user is triggered at the moment of opening the door. In a further embodiment, additionally or alternatively, a supervisor may be notified that a user has gained access to the MR examination room and/or that the time interval the respective user is allowed to spend in the MR examination room is about to elapse. The supervisor may be notified via a device such as a pager or an application on the mobile phone.

In a further optional embodiment, the system is configured to determine whether the user is still in the room. This can be realized by camera detection inside the room or by using a sensor system at or near the door, capable of measuring when a person enters and/or leaves the room. The camera detection system may comprise a camera and/or ultrasound sensor for detection of movement of a user in the room, and/or thermal imaging camera, for detection of a user even in the circumstances when the user might not carry out any detectible movement for a certain period, for example when focusing on inspection of a component during servicing components of the MRI system or the examination room. An example of a sensor system implemented at the door is a photoelectric cell, while implementation of a plurality of photoelectric cells at the doorway allows also identification of the direction of movement, allowing the system to determine whether the user entered or left the MR examination room.

Some patients cannot undergo MR exams, because they have metal implants in their body. This can be solid objects like shrapnel or prostheses, but also older tattoo ink. In the case of ferromagnetic objects, the pull force due to high magnetic field can be a risk, additional to radiofrequency heating.

In case that it is unknown whether patients have metallic objects in their body, magnetic resonance imaging is contraindicated for these reasons. This may deprive a significant patient population from the advantages of this diagnostic modality.

According to an aspect of the invention the fast rampable MRI system, comprising a HTS magnet, is configured to operate at least at two magnetic field strengths. One field strength is so low that it does not pose a threat to a metal object carrying patient, but still high enough to generate meaningful images. This field strength is then used to generate images that do not need good signal-to-noise or perfect shimming, it only needs to facilitate metal detection.

The other field strength is higher, preferably some mid-field strength like 0.5T or 0.6T. This is also the field strength the system is optimally shimmed for, in order to generate high-quality images.

According to an embodiment the system comprises a fast-rampable magnet, for example an HTS magnet 304, a dual-resonance radiofrequency system 314 and a computer system 100 on which an image-based metal detection method is implemented. Optionally, the system may operate according to a decision logic that drives the system to automatically ramp-up the magnet based on the findings of the metal detection method.

When a patient is identified potentially carrying metal containing objects or when it is unknown whether the body of the patient comprises any metal content, the MRI system is ramped down to the low field strength, and low-field scanning is performed. A typical low field in this context could be in the range of 0.1T to 0.3T. With these field strengths the RF wavelengths are much larger than the human body and thus the resonance condition for potential RF heating can hardly be met for a typical implant. Ferromagnetic objects may be subject to magnetic forces. These forces would typically be very small for objects that have not already been detected by a standard metal detector. Any imaging sequence could be used, although those with low specific absorption rate (SAR), related to measure of the amount of power deposited by a radiofrequency field in a certain mass of tissue, would be preferred.

In an example, whole-body imaging is performed. Based on the images, the system determines, for example with use of artificial intelligence (AI), if there are portions of the body of the patient comprising metal. This is performed through a standard image feature detection task. An AI (e.g., a CNN, UNet, or similar implementation) is trained to classify images regarding their metal artifact content. Training data are MR images of similar contrasts with and without metal artifacts. Training data can even be generated synthetically by solving Bloch equations for a 2D or 3D distribution of tissue and metal. In the event of a positive finding, the outcome is that the patient cannot be scanned or imaged with MRI without further action.

Since the magnet is supposed to generate high-quality images at higher field strength, it is optimally shimmed to this higher field strength. At the lower field strength, the shimming is somewhat off, so that the artificial intelligence-based metal-detection has to be trained to be tolerant with respect to some artifacts. Metal artifact training can be performed in the presence of shim artifacts. Since this is only a binary classification and metal artifacts are typically very clearly visible, the AI model should be able to distinguish between a metal-free anatomy and a metal-containing anatomy even under the condition of suboptimal shimming. The suboptimal shimming could even be considered in the generation of synthetic training data. The severity of these artifacts can be mitigated by employing active shims, for example. The lower field strength in fact, is more advantageous in this respect, since the active shims need to compensate smaller field errors at lower field.

If the low-field scan has a negative outcome, i.e. no part of the body has been identified comprising metal-content, the system ramps the magnet up to full field strength. Depending on the difference between the two field strengths, this can be done within a few minutes. The low-field images may still be of a good enough quality, so the ramp-up time can be well used for planning of the subsequent scans. Once the scanner is up to the high target field strength, the operator of the system can obtain high-quality images.

In any of the embodiments notifying or warning may be performed by a visual signal and/or an audible signal. Visual signal may comprise any of graphical, textual presentation of information and their combination. Any notification and/or warning may be carried out by a mobile device, such as for example a smartphone, and/or a fixed device such as for example a display screen of a console or connected to the console and/or a projecting device.

It is understood that one or more of the aforementioned embodiments of the invention may be combined as long as the combined embodiments are not mutually exclusive.

Although various embodiments of the claimed subject matter have been described above with a certain degree of particularity, or with reference to one or more individual embodiments, those skilled in the art could make numerous alterations to the disclosed embodiments without departing from the spirit or scope of the claimed subject matter.

Still other embodiments are contemplated. It is intended that all matter contained in the above description and shown in the accompanying drawings shall be interpreted as illustrative only of particular embodiments and not limiting. Changes in detail or structure may be made without departing from the basic elements of the subject matter as defined in the following claims.

## Claims

1. A method of operating a rampable magnetic resonance imaging, MRI, system, comprising:
presenting a resettable count-down timer to a user, wherein the count-down starts from a predefined value;
resetting the count-down timer to the predetermined value upon interaction of a user;
assessing current use of the MRI system based on whether an examination is ongoing or whether an examination is scheduled within a predetermined time interval;
ramping down the magnetic field strength of the MRI system when the duration of period associated to the predefined value elapses and when current use of the MRI system is not established.

2. The method according to claim 1, further comprising:
presenting the user a warning signal when the duration of period associated to the predefined value is about to elapse.

3. The method according to claim 2, wherein the warning signal is a visual and/or an audible signal.

4. The method of any of the preceding claims, wherein the predetermined value is set by an operator of the MRI system or it is selected from a list of predetermined values through a user interface.

5. The method according to any of the preceding claims, further comprising:
receiving information about an actual active magnetic field strength associated to the MRI system;
receiving a request from a user willing to access a location wherein the MRI system is sited;
receiving a user access profile associated to the user requesting access to the location;
granting user access to the location when the actual active magnetic field strength is conform to the user access profile.

6. The method of claim 1, wherein ramping down the magnetic field strength of the MRI system to a first predetermined field strength value is performed when the duration of period associated to the predefined time interval value elapses and when current use of the MRI system for high-resolution imaging is not established;
the method further comprises:
scanning at least one portion of a subject at magnetic field strength according to the first predetermined value;
detecting from the scanning whether the at least one portion of the subject comprises metal;
ramping up the magnetic field strength of the MRI system to a second predetermined field strength value based on detecting no metal being comprised by the at least one portion of the subject, wherein the second predetermined field strength value is larger than the first predetermined field strength value;
imaging the at least one portion of the subject at magnetic field strength according to the second predetermined field strength value.

7. A method (400) of controlling access to a location wherein a rampable magnetic resonance imaging, MRI, system is situated, comprising:
receiving information about an actual active magnetic field strength associated to the MRI system;
receiving a request from a user willing to access the location wherein the MRI system is situated;
receiving a user access profile associated to the user requesting access to the location;
granting user access to the location when the actual active magnetic field strength is conform to the user access profile.

8. The method of claim 5 or 7, further comprising:
notifying the user when the time interval permitted to be spent in the location is about to elapse.

9. The method of claim 8, wherein the time interval permitted to be spent in the location by the user is associated to the user access profile.

10. The method of any of the claims 5 and 7 to 9, further comprising:
notifying a supervisor of the location that the user has gained access to the location and/or that the time interval the respective user is allowed to spend in the location is about to elapse.

11. The method of any of the claims 8 to 10, wherein notifying is performed by a visual signal and/or an audible signal.

12. A method of operating a rampable magnetic resonance imaging system, comprising:
ramping down the magnetic field strength of the MRI system to a first predetermined value;
scanning at least one portion of a subject at magnetic field strength according to the first predetermined value;
detecting from the scanning whether the at least one portion of the subject comprises metal;
ramping up the magnetic field strength of the MRI system to a second predetermined value based on detecting no metal being comprised by the at least one portion of the subject, wherein the second predetermined value is larger than the first predetermined value;
imaging the at least one portion of the subject at magnetic field strength according to the second predetermined value.

13. A system for safe operation of a magnetic resonance imaging system, comprising:
a computational system configured to perform a method according to any of the claims 1 to 12.

14. The system of claim 13, further comprising:
a rampable magnetic resonance imaging system for providing magnetic resonance imaging data;
a display screen configured to display information output by the computational system.

15. A computer program comprising machine executable instructions, wherein execution of the machine executable instructions causes a computational system to perform a method according to any of the claims 1 to 12.
